# EUROPÄISCHE PATENTSCHRIFT

(11) **EP 1 820 220 B1**
(45) Veröffentlichungstag und Bekanntmachung des Hinweises auf die Patenterteilung: **04.06.2014**
(21) Anmeldenummer: 04741759.7
(22) Anmeldetag: 09.06.2004
(51) Int. Cl.: H01L 33/00, H01L 33/50

(54) **VERFAHREN ZUR HERSTELLUNG WEISSER LEUCHTDIODEN**
METHOD FOR THE PRODUCTION OF WHITE LIGHT EMITTING DIODES
Procede de production de diodes electroluminescentes blanches

(30) Priorität: 18.06.2003 AT 9482003
(43) Veröffentlichungstag der Anmeldung: 22.08.2007
(60) Teilanmeldung: 10185808.2
(73) Patentinhaber: Tridonic Jennersdorf GmbH, 8380 Jennersdorf (AT)
(72) Erfinder: Leising, Günther, 8042 Graz (AT)
(74) Vertreter: Rupp, Christian
(86) Internationale Anmeldenummer: PCT/EP2004/051065
(87) Internationale Veröffentlichungsnummer: WO 2004/112152

(56) Entgegenhaltungen:
- EP-A- 1 081 771
- WO-A-03/038902
- DE-A1- 10 135 306

## Beschreibung

### Technisches Umfeld

Die Erfindung betrifft ein Verfahren zur Herstellung einer weißes Licht mit vorgegebener Farbtemperatur aussendenden Licht emttlierenden Diode (=LED), im Folgenden als "weiße LED" bezeichnet, bei dem eine blaues Licht aussendende LED, im Folgenden als "blaue LED" bezeichnet, oder eine UV-Licht aussendende LED, im Folgenden als "UV-LED" bezeichnet, mit einer Konversionsschicht, die blaues Licht bzw. UV-Licht absorbiert und Licht größerer Wellenlänge emittiert, beschichtet wird.

Bei einer blauen LED wird ein Teil der blauen Emission in einen anderen Wellenlängenbereich konvertiert, so dass die Summe der emittierten Lichtkomponenten weißes Licht ergibt. Bei einer UV-LED muss die Konversionsschicht natürlich zumindest zwei verschiedene Farbkonversionspigmente enthalten, deren Emissionen zusammen weißes Licht ergeben. Die Erfindung betrifft weiters eine weiße LED-Lichtquelle, die mehrere blaue LED's oder UV-LED's aufweist, über denen eine Konversionsschicht aufgebracht ist.

Die Farbkonversionsschicht besteht typisch aus anorganischen oder organischen Farbkonversionspigmenten, welche in einer organischen Kunststoffschicht verteilt sind.

Im Hinblick auf eine reproduzierbare Herstellung von weißen LEDs innerhalb enger Toleranzen des resultierenden Farbortes muss beim Herstellungsprozess neben der Konzentration der Pigmente auch die Schichtdicke (und deren Form) exakt definiert sein.

Aus dem Stand der Technik nach JP 8335719 A und JP 8335720 A ist bekannt, dass Farbkonversionsmedium in den Reflektor-Cup gefüllt ist, in welchen die LED eingesetzt wird. Ferner ist aus US 5959316 A und JP 10190065 A bekannt, dass ein Farbkonversionsmedium in Tropfenform über dem LED-Chip mit transparentem Spacer aufgebracht wird.

Aus der US 6590235 B ist bekannt, dass ein Farbkonversionsmedium in die Klebeschicht zwischen der LED und einer Linse eingebracht wird.

Aus der EP 1081771 A ist bekannt, dass ein Farbkonversionsmedium in Schichtform definiert hergestellt und auf der LED befestigt wird.

JP 2001244507 A offenbart, dass eine Farbkonversionsschicht direkt auf den LED-Chip gedruckt wird.

Die DE 10135 306 offenbart ein Verfahren zur Herstellung einer weißen Lichtquelle mit einheitlicher Farbtemperatur. Dabei werden auf einem Wafer eine Anzahl Leuchtdioden ausgebildet, dann die wellenlänge des Lichts der Leuchtdioden gemessen und entsprechend unterschiedliche Mengen Phosphorstoffe auf den Leuchtdioden durch Tintenstrahldruck aufgebracht.

Die WO 03/038902 offenbart die Auftragung von unterschiedlich dotierten Phosphormaterialien oder einer unterschiedlichen Menge an Phosphormaterial auf Leuchtdioden in Abhängigkeit einer zuvor ermittelten Wellenlänge der jeweiligen Leuchtdioden.

Diese Methoden erfüllen die Anforderungen für viele Anwendungen, speziell für Beleuchtung, unzureichend. Die Herstellungsmethode und deren Toleranzen sind wesentliche Gründe für die Abweichungen. Ein weiterer Grund ist der folgende :

Die Anregbarkeit der Farbkonversionsmittel hängt typischerweise stark von der Wellenlänge der anregenden LEDs ab. Speziell bei langwelligen blauen LEDs führt eine Wellenlängentoleranz von nur einigen Nanometer bereits zu signifikant unterschiedlichen Emissionsintensitäten bei den derzeitigen Farbkonversionsmitteln. Im Falle von UV-LEDs würde dies vorwiegend zu einer Intensitätsschwankung führen, im Falle von blauen LEDs darüber hinaus zu einer Farbverschiebung, da sich in diesem Fall das weiße Licht aus der blauen LED-Emission und der Emission des Farbkonversionsmittels zusammensetzt.

Da LEDs gemäß dem Stand der Produktionstechnik eine relativ breite Wellenlängenverteilung aufweisen, weist eine typische Selektionsklasse eine Wellenlängentoleranz von mehr als 5 nm auf. Selbst bei sehr definierter Aufbringung der Farbkonversionsmittel (mit vernachlässigbarer Toleranz) resultiert hieraus eine Toleranz der Farbtemperatur weißer LEDs von mehr als ±300 K. Dies ist für viele Anwendungen bereits zu hoch. Es entspricht daher dem Stand der Technik, dass die Marktforderung nach enger spezifizierten weißen LEDs durch Selektionsverfahren realisiert wird.

### Offenbarung der Erfindung

Es ist Aufgabe der Erfindung, ein Verfahren zur Herstellung weißer LEDs zu schaffen, weiche geringere Toleranz der Farbtemperatur haben, als es dem Stand der Technik entspricht. Weiter soll eine weiße LED-Lichtquelle geschaffen werden, die eine geringere Schwankungsbreite der Farbtemperatur hat, die insbesondere also über der gesamten Emissionsfläche eine nahezu konstante Farbtemperatur hat.

Diese Aufgabe wird durch ein Verfahren gemäßAnspruch 1 gelöst. Die Unteransprüche stellen weitere bevorzugte Ausführungsbeispiele der Erfindung dar.

Im Gegensatz zum Stand der Technik ist durch das erfindungsgemäße Verfahren eine Herstellung von weißen LEDs mit definierter Farbtemperatur und definierter Toleranz möglich, ohne dass ein weiteres Selektionsverfahren notwenig wäre.

Der Herstellungsprozess kann grob folgendermaßen beschrieben werden:

LEDs werden in Wafern hergestellt. Es entspricht dem Stand der Technik, dass die einzelnen LEDs auf einem Wafer einzeln bezüglich Helligkeit und Wellenlänge (Δ λ < 1nm) vermessen werden (Wafer Mapping, siehe Produktspezifikation der Maschinenhersteller, z.B. ASM). Diese Daten werden in weiterer Folge dazu verwendet, die LEDs nach dem Vereinzeln in verschiedene Klassen zu selektieren. Alternativ können die optischen Daten der LEDs einzeln vor der Aufbringung der Farbkonversion mittels Spektrometer (oder Chromameter) gemessen werden.

In gegenständlicher Erfindung wird die Information des Wafer Mappings dazu benutzt, um auf jede LED selektiv eine spezielle Menge Farbkonversionsmittel aufzubringen. Die Menge an Farbkonversionsmittel ist hierbei selektiv z.B. durch entsprechende Wahl der Schichtdicke oder der Konzentration (bei verdünnten Systemen) auf die jeweilige LED abgestimmt.

Bei der Aufbringung des Parbkonversionsmittels gibt es folgende Möglichkeiten:
Selektives Dispensen oder Stempeln
Selektives Inkjet Printing
Selektives Verdampfen durch Masken
Selektives nachträgliches Einstellen der Dicke und Form der Schicht des Farbkonversionsmittels (z.B. durch Laser wie beim Widerstandstrimmen).

Zur Vereinfachung werden die LEDs in Gruppen zusammengezogen, z.B. jeweils im Bereich von 1 nm.

### Kurze Beschreibung von Zeichnungen

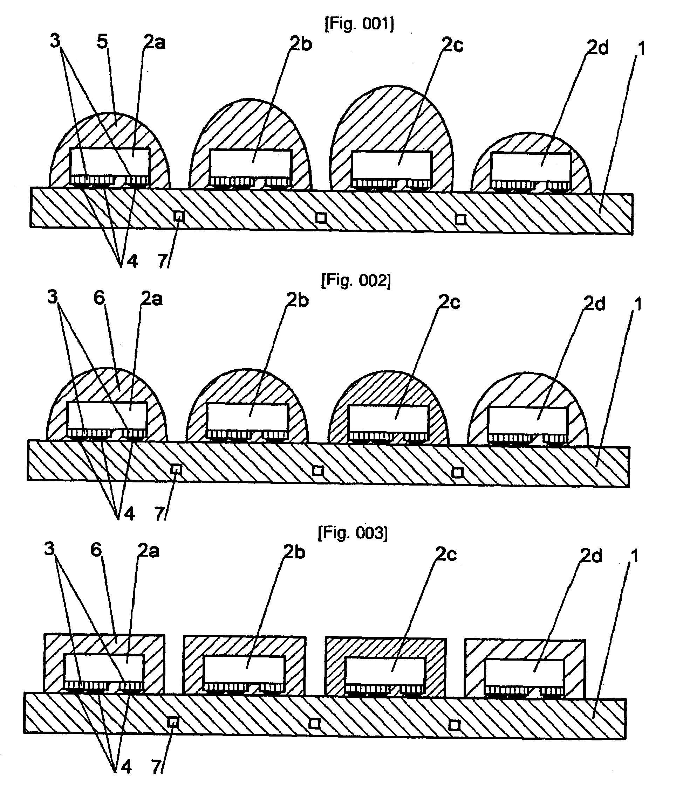

Anhand der Zeichnung wird die Erfindung näher erläutert. Es zeigt: Fig. 1 LED's mit unterschiedlicher Menge von Binder, in dem sich das Farbkonversionsphos-phorpigment befindet; Fig. 2 LED's mit gleichen Mengen von Binder, in dem sich das Farbkonversionsphosphorpigment mit unterschiedlicher Konzentration befindet; und Fig. 3 zeigt eine Abwandlung der Ausführungsform gemäß Fig. 2.

Es folgen nun fünf Beispiele:

### I.) Beispiel, nicht Teil der Erfindung. Farbkonversionsphosphorpigment dispergiert in organischem Binder mit konstanter Konzentration - Aufbringen mittels Dispenser

In Fig. 1 ist eine Platine 1 gezeigt, auf der sich vier LED-Chips 2a, 2b, 2c, 2d befinden. Diese LED-Chips 2a, 2b, 2c, 2d sind in Flip-Chip-Technologie aufgebracht, d.h. die Anschlüsse 3 befinden sich auf der Unterseite und sind mit Kontakt-Bumps 4 mit der Platine 1 verbunden. Über jedem LED-Chips 2a, 2b, 2c, 2d befindet sich ein Tropfen eines Binders 5, der das Farbkonversionsphosphorpigment enthält.

Man stimmt die Tropfenmenge auf die Wellenlänge der LED-Chips 2a, 2b, 2c, 2d ab. Gemäß der ermittelten Wellenlänge der einzelnen LED-Chips 2a, 2b, 2c, 2d wird die Tropfenmenge erhöht für langwellige LED-Chips 2b, 2c, während diese für kurzwellige LED-Chips 2d reduziert wird. Da die Viskosität und Thixotropie der Paste von der Konzentration des Farbkonversionspigmentes abhängt, kann auch eine Veränderung der Tropfenform erzielt werden (bei einer volumetrischen Dosierung).

Mit diesen Methoden konnte durch eine Variation des Dispens-Volumens zwischen 0,02 und 0,03 cm³ auf Chips deren Wellenlängen zwischen 460 und 475 nm variierten, weißes Licht mit einer Farbtemperatur von 6500 ± 300 K realisiert werden.

### II.) Ausfuhrungsbeispiel der Erfindung. Farbkonversionphosphorpigment dispergiert in organischem Binder mit variabler Konzentration - Aufbringen mittels Dispenser.

Gemäß der Wellenlänge der einzelnen LED-Chips 2a, 2b, 2c, 2d (siehe Fig. 2) wird die Konzentration der Phosphorpigmente im Binder 6 in der Matrix adaptiert. Dies wird bevorzugt durch das Verwenden von mehreren Dispens- oder Stempelbehältem mit unterschiedlichen Konzentrationen der Phosphorpigmente erreicht. Die unterschiedliche Konzentration ist in Fig. 2 durch Schraffen mit unterschiedlichem Abstand angedeutet.

Optional kann nach dem Dispens- oder Stempelvorgang ein Druckvorgang angeschlossen werden, um eine ebene und definierte Form des Farbkonversionsmediums zu erreichen (siehe Fig. 3). Hiezu wird über der LED-Anordnung eine Maske aufgelegt, in deren Ausnehmungen das Farbkonversionsmedium mittels Dispenser aufgebracht wird. Abschließen wird mittels eines Rakels das über die Maske herausstehende Material entfernt.

Mit diesen Methoden konnte durch eine Variation des Phosphorpigmentes in der organischen Matrix zwischen 10 und 30 Masse-% auf Chips mit einer Wellenlängenvariation zwischen 460 und 475 nm weißes Licht mit einer Farbtemperatur von 6500 ± 200 K realisiert werden.

Die Methoden I und **II** werden bevorzugt für LED-Chips eingesetzt, die Face Down (Elektrode nach unten) auf Trägermaterialien (Halbleiterträger oder printed circuit board = PCB) angeordnet sind, da es bei einer Face Up Montage schwierig ist, die Elektroden frei von der Farbkonversionspaste zu halten. Die derart montierten LEDs werden in einem Mapping-Verfahren einzeln bezüglich der Wellenlänge vermessen und mit diesen Daten wird der Dispenser programmiert. Die einzelnen LEDs können nachfolgend entlang von Trennlinien 7 geteilt und zu LED-Lichtquellen verarbeitet werden bzw. auch als LED-Modul eingesetzt werden.

### III.) Ausfuhrungsbeispiel der Erfindung. Farbkonversionsphosphorpigment dispergiert in organischem Binder-Aufbringen mittels Inkjet Printing.

Das Inkjet Printing stellt eine Verfeinerung der Dispensmethode II dar. Hiezu sind feinkörnige Pigmente (im Bereich von höchstens einigen Mikrometern Durchmesser) notwendig.

Die individuelle Einstellung der Farbkonversion pro LED kann derart mittels der Konzentration der gesetzten Inkjettropfen durch Einsatz verschiedener Inkjet-Tinten (aus verschiedenen Kartuschen) erfolgen.

### IV.) Beispiel, nicht Teil der Erfindung. Aufbringen der Farbkonversionsmaterialien aus der Gasphase

Gemäß dem Stand der Technik sind einige Materialien (ZnS:Mn) bekannt, die sich zur Farbkonversion des von LEDs ausgesandten Lichts eignen und welche mittels Gasphasenmethoden abgeschieden werden können.

Einer der Vorteile dieser Methoden ist, dass die Elektroden der LEDs selektiv abgedeckt werden können und daher diese Methode auch für Face Up montierte LEDs sehr gut geeignet ist. (Man kann die Kontaktflächen einfach abdecken.)

Die selektive Farbkonversion wird bei dieser Methode durch definierte Einstellung der aufgebrachten Menge des Farbkonversionsmaterials erreicht. Dies kann im einfachsten Fall durch Anbringen einer Maske (typisch Photomaske), die speziell auf den zu beschichteten LED Wafer (gemäß den Wafer Mapping Daten) abgestimmt ist, erfolgen. Derart wird eine LED mit der höchsten Wellenlänge (was normalerweise beste Anregbarkeit bewirkt) vollständig beschichtet, während bei LEDs mit geringerer Wellenlänge nur Teile der Oberfläche beschichtet werden.

### V.) Beispiel, nicht Teil der Erfindung. Trimmen der Dicke und Form der Farbkonversionsschicht

Das Einstellen der Farbkonversion bei vollflächig aufgebrachten Schichten (gleicher Konzentration) kann auch nachträglich erfolgen. Hiezu kann ein Verfahren angewandt werden, welches in der Halbleiter- und Drucktechnik eingesetzt wird, um z.B. Widerstände definiert abzugleichen. Hiezu wird die beschichtete LED derart getrimmt, dass ein Laser Farbkonversionsmaterial von der Oberfläche der LEDs definiert abträgt (Laserablation), sodass die gewünschte Farbe durch die definierte Menge an übrig gelassenem Farbkonversionsmaterial unabhängig von der Wellenlänge der LED erreicht wird.

## Patentansprüche

1. Verfahren zur Herstellung einer weißen Leuchtdiode (LED), mit vorgegebener Farbtemperatur, aufweisend die Schritte.
- Ermittlung der genauen Wellenlänge eines blauen oder UV-LED-Chips (2a, 2b, 2c, 2d)
- Ermittlung der Konzentration eines Farbkonversionsmittels, welches auf den blauen oder UV-LED Chip aufzubringen ist, basierend auf der ermittelten Wellenlänge des jeweiligen LED-Chips wobei das Farbkonversionsmittel blaues Licht bzw. UV-Licht absorbiert und Licht größerer Wellenlänge emittiert, und
- Beschichtung des blauen oder des UV-LED-Chips mit einer Konversionsschicht, welche die ermittelte Konzentration des Farbkonversionsmittels aufweist.

2. Verfahren nach Anspruch 1,
wobei das Farbkonversionsmittel mittels Dispenser oder Stempel aufgebracht wird.

3. Verfahren nach Anspruch 1,
wobei das Farbkonversionsmittel durch Inkjet-Printing aufgebracht wird.

## Claims

1. Method for the production of a white light emitting diode (LED) having a predefined colour temperature, comprising the steps:
- determining the exact wavelength of a blue or UV LED chip (2a, 2b, 2c, 2d),
- determining the concentration of a colour conversion agent which is to be applied to the blue or UV LED chip, based on the wavelength of the respective LED chip that was determined, the colour conversion agent absorbing blue light or UV light and emitting light of greater wavelength, and
- coating the blue or UV LED chip with a conversion layer which has the concentration of the colour conversion agent that was determined.

2. Method according to Claim 1,
wherein the colour conversion agent is applied by means of a dispenser or stamp.

3. Method according to Claim 1,
wherein the colour conversion agent is applied by means of inkjet printing.

## Revendications

1. Procédé destiné à la production d'une diode électroluminescente (LED) blanche avec une température de couleur prédéterminée, présentant les étapes:
- détermination de la longueur d'onde exacte d'une puce à LED bleue ou à UV (2a, 2b, 2c, 2d),
- détermination de la concentration d'un moyen de conversion de couleur, lequel est destiné à être appliqué sur la puce à LED bleue ou à UV, sur la base de la longueur d'onde déterminée de la puce à LED respective, dans lequel le moyen de conversion de couleur absorbe de la lumière bleue ou de la lumière UV et émet de la lumière de plus grande longueur d'onde, et
- revêtement de la puce à LED bleue ou à UV avec une couche de conversion, laquelle présente la concentration déterminée du moyen de conversion de couleur.

2. Procédé selon la revendication 1,
**caractérisé en ce que** le moyen de conversion de couleur est appliqué au moyen d'un distributeur ou d'un tampon.

3. Procédé selon la revendication 1,
**caractérisé en ce que** le moyen de conversion de couleur est appliqué au moyen d'une impression jet d'encre.
